Europäisches Patentamt

(19) European Patent Office

Office européen des brevets

(11) Publication number: **0 279 104 B1**

# (12) EUROPEAN PATENT SPECIFICATION

(45) Date of publication of patent specification: **21.08.91**  (51) Int. Cl.⁵: **B41M 5/26**, G03C 1/76, G03C 1/00, G03F 7/00

(21) Application number: **87308007.1**

(22) Date of filing: **10.09.87**

(54) Image producing material.

(30) Priority: **06.02.87 JP 25647/87**
**27.03.87 JP 75514/87**
**22.06.87 JP 155223/87**

(43) Date of publication of application:
**24.08.88 Bulletin 88/34**

(45) Publication of the grant of the patent:
**21.08.91 Bulletin 91/34**

(84) Designated Contracting States:
**DE FR GB**

(56) References cited:
**FR-A- 2 536 014**
**GB-A- 2 113 860**
**GB-A- 2 160 671**

(73) Proprietor: **SEIKO INSTRUMENTS INC.**
**31-1, Kameido 6-chome Koto-ku**
**Tokyo 136(JP)**

(72) Inventor: **Sakojiri, Hiromichi**
**31-1, Kameido, 6-chome Koto-ku**
**Tokyo(JP)**
Inventor: **Takahashi, Hiroshi**
**31-1, Kameido, 6-chome Koto-ku**
**Tokyo(JP)**

(74) Representative: **Miller, Joseph et al**
**J. MILLER & CO. Lincoln House 296-302 High Holborn**
**London WC1V 7JH(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to an image producing material and, although the invention is not so restricted, it relates more particularly to a multicolour image producing material for producing multicolour images.

Multicolour images have previously been produced by record producing systems such as electron photography, electrostatic record producing,current application record producing, heat-sensitive record producing, and ink jet record producing. Further, much research has been conducted to develop a record producing system utilizing microcapsules, and various systems such as a pressure sensitive record producing system, a heat-sensitive record producing system and so on have already been invented. Patents which concern such record producing systems are, for example, US-A-4,399,209, 4,440,849, 4,501,809, and 4,621,040.

US-A-4,399,209 is directed to a transfer image producing system which comprises a layer of microcapsules wherein a chromogenic material is encapsulated with a photosensitive composition. The photosensitive composition comprises a radiation-curable composition which upon exposure causes an increase in its viscosity,thereby preventing diffusion of the chromogenic material upon rupture of the capsules. Upon rupture of the capsules, those capsules in which the radiation-curable material is not activated will release the chromogenic material which will transfer to a developer sheet and react with the developer material to form the image. A similar image producing system, i.e. a so-called self-contained imaging sheet wherein the developer and the photosensitive capsules are carried on a single substrate, is described in US-A-4,440,846.

A colour image producing system employing the aforementioned photosensitive composition encapsulated in pressure-rupturable microcapsules is described in GB-A-2,113,860.

GB-A-2,113,860 discloses a photosensitive material useful in full colour image production comprising a support having on the surface thereof microcapsules which individually contain cyan, magenta and yellow colour formers and photosensitive compositions having distinctly different sensitivities.A uniform mixture of the microcapsules is distributed over the surface of the support. Images are formed by separating the red, green and blue components of the image to be reproduced and translating these components into different wavelengths of actinic radiation to which the photosensitive compositions are distinctly sensitive. The photosensitive material is image-wise exposed to the translated radiation and thereafter it is subjected to a uniform rupturing force, such as pressure, which causes the microcapsules in the under-exposed and unexposed areas to rupture and release the colour formers. The colour formers then react with a developer material which is contained on the same or a different support and produce a full colour image.

In the case of the prior techniques referred to above, the ink jet method involves a problem of clotting and is not sufficiently reliable, while the other record producing methods require many complicated steps for recording the three primary colours repeatedly from a CRT, etc. In particular, in the case of the known record producing material using capsules, the production of a coloured record is carried out by reacting one colouring component incorporated in a capsule with another colouring component which is present outside the capsule by effecting rupture of the capsule walls by applied pressure. For this purpose, a pressure roll is required which has a force of 200-400 pounds per linear inch (357.16 - 7143.2 kg/m) to break the capsules.

In FR-A-2,536,014 there is disclosed a material comprising a number of chromogenic systems each containing a chromogenic material and a material for developing the colour, each of the said systems containing a substance which absorbs infra-red rays of a respective wavelength.

According to the present invention, there is therefore provided an image producing material comprising a substrate which carries a plurality of colour containers each of which contains a colour former which is released when the respective colour container is subjected to a predetermined process, the image producing material comprising developer material with which the respective colour former, when so released, reacts to produce a colour image characterised in that each of the colour containers comprises infra-red absorbent material which produces the said release of the colour former when the respective colour container is subjected to infra-red light of a predetermined wavelength.

Preferably, each colour container is a heat-meltable microcapsule which is caused to melt when the respective infra-red absorbent material is subjected to infra-red light of a predetermined wavelength.

The respective microcapsules preferably contain colour formers of different colours, each microcapsule comprising infra-red absorbent material which is responsive to infra-red light whose wavelength differs from that to which the infra-red absorbent mateial of a colour container which contains a colour former of a different colour is responsive. Thus the microcapsules preferably comprise first microcapsules containing a cyan colour former and infra-red absorbent material responsive to a first wavelength, second microcapsules containing a magenta colour former and infra-red absorbent material responsive to a second wavelength, and third microcapsules containing a yellow colour former and infra-red absorbent material responsive to a third wavelength.

The colour containers are preferably in a layer which is provided on a developer material layer or which contains developer material.

Each microcapsule may have a porous membrane within which the colour former is encapsulated. Thus each microcapsule may have inner and outer capsule walls, the porous membrane constituting one of the capsule walls. In this case, the infra-red absorbent material may be located in the other capsule wall.

Alternatively, the porous membrane may constitute an outer capsule wall which contains the infra-red absorbent material.

In one embodiment, each microcapsule has an inner capsule wall which contains the infra-red absorbent material and an outer capsule wall which is made from a heat-meltable substance.

If desired, each microcapsule may comprise a porous micro-globule which contains the colour former, the micro-globule being encapsulated in an outer layer.

Preferably each colour former comprises a leuco dye.

The invention also comprises a process for forming a colour image by the use of the image producing material having the first, second and third microcapsules referred to above, the said process comprising resolving a multicolour image into its red, green and blue component parts; causing each of said component parts to generate a respective actinic infra-red ray whose wavelength differs from that of the other said rays; directing the said rays onto the microcapsules so that the latter are heated by adsorbing the said rays; and producing a multicolour image by causing or permitting the colour formers of the microcapsules to react with the developer material.

The present invention enables multicolour images to be obtained in a simple process at a high speed.

The present invention, moreover, enables an image to be produced without rupturing capsules by pressure application.

The colour former may be an electron donating chromogenic material dissolved in an organic solvent. The colour former may be located in or dissolved in a micro-globule. The micro-globule may be contained in a heat-meltable substance and may enclose the infra-red absorbent material. If desired, the infra-red absorbent material can be present in a porous membrane or in a heat-meltable substance.

The image producing material of the present invention is preferably stable during normal handling and under general conditions, but if it is exposed to the infra-red rays which may be generated from red, green and blue images, the microcapsule is heated through adsorption of the infrared rays and its outer capsule wall is melted. As a result of the melting of the outer capsule wall, its colour may pass through an inner capsule wall composed of a porous former membrane so as to ooze out, or a colouring component, which constitutes the said developer material, and which is present outside the microcapsules may pass through the capsule wall and permeate into the inside of individual capsules.

Whether in the former case or in the latter case, colour formation takes place.

The invention is illustrated, merely by way of example, in the accompanying drawings, in which:-

Figure 1 illustrates a first embodiment of a microcapsule forming part of an image producing material in accordance with the present invention;

Figure 2 illustrates a second embodiment of a microcapsule forming part of an image producing material according to the invention;

Figure 3 illustrates a third embodiment of a microcapsule forming part of an image producing material according to the invention;

Figure 4 shows a first embodiment of a multicolour image producing material according to the present invention using the microcapsules shown in Figure 1 or Figure 2, or microcapsules incorporating porous micro-globules as shown in Figure 3;

Figure 5 is a diagram illustrating the subjection of the multicolour image producing material shown in Figure 4 to light of different wavelengths;

Figure 6 is a schematic view illustrating a second embodiment of an image producing material according to the present invention;

Figure 7 is a schematic view illustrating the use of laser beam radiation to produce an image by employing the image producing material shown in Figure 6; and

Figure 8 is a schematic view of a third embodiment of an image producing material according to the present invention.

In one embodiment of an image producing material according to the present invention, the material comprises a substrate having provided thereon a capsule layer comprising a plurality of heat-meltable microcapsules and a developer material for reacting with a colour former contained in the microcapsules to form colours. Each heat-meltable microcapsule has a capsule wall including an infra-red absorbent. The capsule wall is a double capsule wall comprising an inner and an outer capsule wall. The inner capsule wall is composed of a porous membrane or a heat-meltable substance. The infra-red absorbent comprises a substance which absorbs infra-red rays of a specified wavelength for causing a colour reaction but which substantially does not absorb infra-red rays of a different wavelength for causing another colour reaction. That is, the colour former, such as a leuco dye, reacts with the developer material to produce the required colour by absorbing infra-red rays of a specified wavelength. Such an image producing material enables multicolour images to be produced at high speed in a simple process utilizing infra-red rays of a plurality of different wavelengths. Thus, a multicolour image producing material may comprise a substrate having provided thereon at least two microcapsules or porous micro-globules separately containing therein leuco dyes of respective colours capable of forming at least two different colours, and colour developers for reacting with the respective leuco dyes to form colours, the microcapsules or porous micro-globules containing infra-red absorbents, which are respectively responsive to different wavelengths for the respective colours, either in an inner capsule wall which encapsulates the leuco dyes or in an outer capsule wall comprising a porous membrane or a heat-meltable substance.

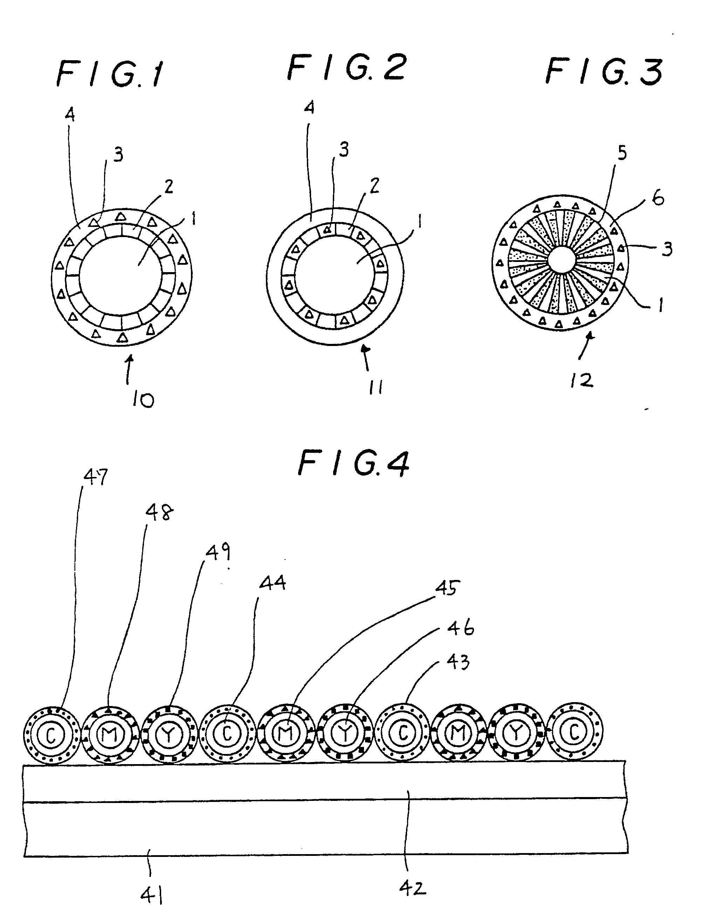

Figure 1 illustrates a first embodiment of a microcapsule forming part of an image producing material according to the present invention. In Figure 1, a microcapsule 10 contains a leuco dye as a core material 1, an infra-red absorbent 3 and a heat-meltable substance 4. The microcapsule 10 is heat-meltable and has double capsule walls comprising a porous membrane 2 as an inner capsule wall and the heat-meltable substance 4 as an outer capsule wall. The outer capsule wall may be a porous membrane.

Figure 2 illustrates a second embodiment of a microcapsule forming part of an image producing material according to the present invention. In Figure 2, a meltable microcapsule 11 has an inner capsule wall formed by a porous membrane 2 which includes an infra-red absorbent 3. In Figure 2, the capsule wall 2 is encapsulated in a porous membrane or a heat-meltable substance 4.

Figure 3 illustrates a third embodiment of a microcapsule forming part of an image producing material according to the present invention. In Figure 3, a microcapsule 12 comprises a porous micro-globule 5. The porous micro-globule 5 contains a leuco dye 1, the micro-globule 5 being encapsulated in a porous membrane or a heat-meltable substance 6. The porous membrane or heat-meltable substance 6 contains an infra-red absorbent 3.

Figure 4 shows a first embodiment of a multicolour image producing material according to the present invention using the microcapsules shown in Figure 1 or Figure 2, or microcapsules incorporating the porous micro-globules 5 shown in Figure 3. The material shown in Figure 4 comprises a developer material layer 42 having colour developers which respectively react with the leuco dyes to form colours, the developer material layer 42 being coated on a substrate 41. The material comprises three kinds of microcapsules or porous micro-globules 43 containing respectively a cyan leuco dye 44, a magenta leuco dye 45 and a yellow leuco dye 46, these microcapsules or micro-globules being coated as a homogeneous mixture on the developer material layer 42. The microcapsules or porous micro-globules which respectively have the cyan, magenta and yellow dyes, contain an infra-red absorbent 47 responsive to light of a wavelength $\lambda_1$, an infra-red absorbent 48 responsive to light of a wavelength $\lambda_2$, and an infra-red absorbent 49 responsive to light of a wavelength $\lambda_3$, respectively, at the respective walls or surfaces thereof.

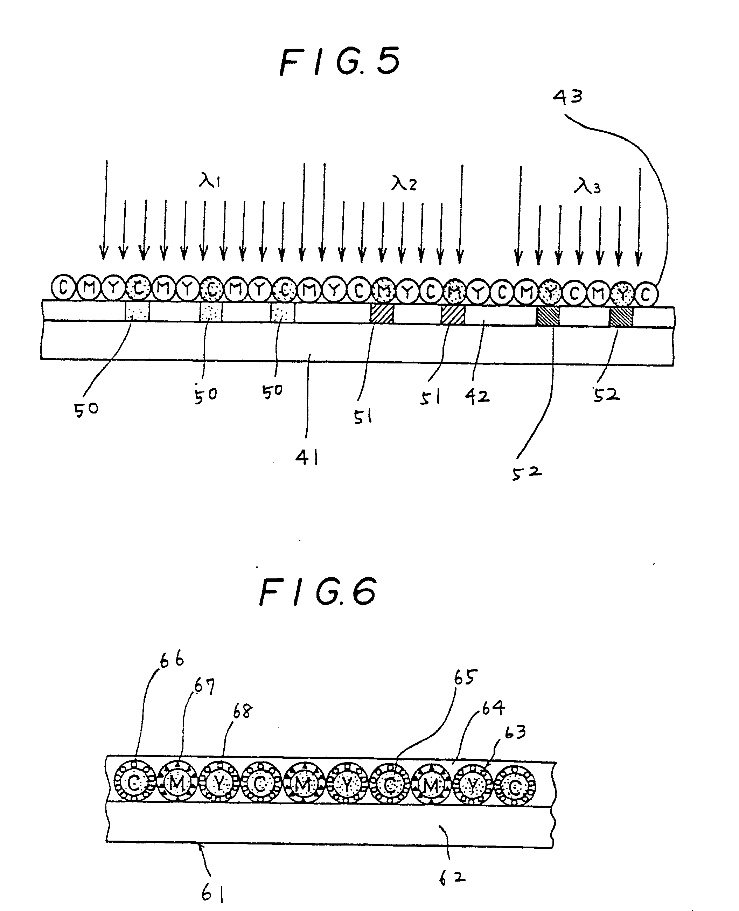

Figure 5 is a diagram illustrating the subjection of the multicolour image producing material shown in Figure 4 to light of different wavelengths. Upon exposure of the said material to infra-red rays having wavelengths $\lambda_1$, $\lambda_2$ and $\lambda_3$, respectively, in response to signals of the three primary colours from a CRT, etc., the microcapsules or porous micro-globules 43 of cyan, magenta and yellow are heated correspondingly by the light of the respective wavelengths, whereby the leuco dyes contained in the respective microcapsules or porous micro-globules 43 respectively react with the colour developers in the layer 42 and a cyan colour portion 50, a magenta colour portion 51, and a yellow colour portion 52 are thus formed in the developer material layer 42 to facilitate subsequent formation of multicolour images. In other words, when infra-red rays having wavelengths of $\lambda_1$, $\lambda_2$, $\lambda_3$ are applied to the image producing material according to signals corresponding to three primary colours, such signals being produced, for example, by a cathode ray tube (CRT), the heat-meltable microcapsules for the individual colours independently generate heat, thereby causing the heat-meltable substance to be melted. This brings about the reaction of the colour formers for the individual colours with the respective developers so as to develop the colours, thereby enabling a colour image comprised of cyan, magenta, and yellow, to be formed. The three primary colours, i.e. the red, green and blue component images, translate into infra-red rays having wavelengths of $\lambda_2$ and $\lambda_3$, infra-red rays having wavelengths of $\lambda_1$ and $\lambda_3$, and infra-red rays having wavelengths of $\lambda_1$ and $\lambda_2$,

respectively.

As methods for producing the microcapsules or porous micro-globules used in the present invention, there can be employed known micro-encapsulation and surface modification processes, for example, a coacervation method (a phase separation method from an aqueous solution such as disclosed in US-A-2,800,457 and 2,800,458); an interfacial polymerization method; an in situ method by monomer polymerization; spray drying as proposed in US-A-3,111,407; an inorganic wall microencapsulation; and a fusion-dispersion-cooling method such as disclosed in GB-A-952,807. Other suitable methods may be employed if desired.

In particular, interface polymerization, in situ polymerization, etc. are preferred as methods for forming the porous membrane.

An example of a method for producing double wall microcapsules includes micro-encapsulating an organic solvent containing leuco dyes by interface polymerization, then mixing the microcapsules with a synthetic resin emulsion containing the infrared absorbents to make a capsule slurry, and then spray drying the slurry to effect double-wall microencapsulation. Further, an example of the surface modification of the porous micro-globules includes mixing porous micro-globules immersed in an organic solvent containing leuco dyes with a synthetic resin emulsion containing infra-red absorbents to make a capsule slurry, and then spray drying the slurry to modify the surface.

Examples of substances which may be employed to make the microcapsules used in the present invention include polyamides, polyesters, polyureas, polyurethanes, urea-formaldehyde resins, melamine resins etc. Substances which may be employed to make the porous membrane and the heat-meltable substance include resins having a low melting point such as ethylene-acrylate copolymers, butadiene-styrene copolymers, polyvinyl acetate, etc. Further examples of the material which may be used for the porous micro-globules include nylon, polyethylene, etc.

Examples of the infra-red absorbents which may be used in the present invention include organic compounds such as cyanine dyes, diamine type metal complexes, and dithiol type metal complexes, etc. and inorganic compounds such as zinc silicate, magnesium silicate, barium sulphate, and barium carbonate, etc.

The leuco dyes which can be employed in the present invention can be fluorane derivatives, triphenylmethane derivatives, phenothiazine derivatives, auramine derivatives, spiropyrane derivatives, etc. and specific examples include crystal violet lactome, 3,3-bis-(p-dimethylaminophenyl)phthalide, 3,3-bis(p-dimethylaminophenyl)-6-aminophthalide, 3,3-bis(p-dimethylamino-phenyl)-6-nitrophthalide, 3,3-bis(p-dimethylaminophenyl)-6-chlorophthalide, 3-dimethylamino-6-methoxyfluorane, 3-dimethylamino-5, 7-dimethylfluorane, 3-diethylamino-5, 7-dimethylfluorane, 3-diethylamino-7-methylfluorane, 3,6-bis-$\beta$-methoyxyethoxyfluorane, 3,6-bis-$\beta$-cyanoethoxyfluorane, benzoyl leuco methylene blue, rhodamine B lactam, 3-CP-aminophenyl-phthalide, etc.

Examples of an organic solvent which can dissolve the leuco dyes employed in the present invention include alkylated naphthalenes, alkylated biphenyls, alkylated terphenyls, chlorinated paraffins, etc.

Examples of the developer material which can be used in the present invention include phenolic compounds such as $\alpha$-naphthol, $\beta$-naphthol, resorcine, hydroquinone, catechol, pyrogallol, etc., activated clay, organic carboxylic acid metal salts, etc.

The substrate used in the present invention may be made of paper, synthetic paper, synthetic resin films, etc.

The other components of an image producing material of the present invention can be coated onto the substrate using a binder.

Examples of the binder include polyvinyl alcohol, methyl cellulose, carboxymethyl cellulose, styrene-butadiene latex, etc.

For effecting the said coating there can be employed a bar coater, a roll coater, a blade coater, an air knife coater, etc.

The infra-red rays required to develop an image producing material in accordance with the present invention, can be produced by a solid laser such as YAG laser, etc; a gas laser such as a carbon dioxide laser, etc; and an infra-red laser such as a semi-conductor laser, etc.

Hereafter the present invention will be described with reference to the examples below, but is not to be deemed to be limited thereto.

Example 1

(Microcapsules A)

To 45 parts by weight of diisopropylnaphthalene having dissolved therein 5 parts by weight of terephthalic acid dichloride were added 1.4 parts by weight of benzoyl leuco methylene blue so as to dissolve therein. The benzoyl leuco methylene blue solution was mixed with an aqueous solution of 3 parts by weight of polyvinyl alcohol in 97 parts by weight of water and the mixture was emulsified and dispersed with a homogenizer to give a dispersion having a mean particle diameter of 10$\mu$. An aqueous solution of 3 parts by weight of diethylene triamine and 3 parts by weight of sodium carbonate in 24 parts by weight of water was added to the dispersion. The mixture was allowed to stand for 24 hours while stirring to give a capsule solution containing benzoyl leuco methylene blue as a core substance.

Next, the microcapsules were collected by filtration and 50 parts by weight of the microcapsules were mixed with 50 parts by weight of zinc silicate, 10 parts by weight of styrene-butadiene latex and 150 parts by weight of water. The mixture was stirred to give a capsule slurry. The capsule slurry was subjected to spray drying using a spray drier for experimental use under conditions comprising an inlet temperature of 130°C, an outlet temperature of 80°C, a pressure of 3.0 kg/cm² and a solution feed rate of 7 ml/min to give Microcapsules A containing zinc silicate in the wall and benzoyl leuco methylene blue as the core substance.

(Microcapsules B)

To 45 parts by weight of diisopropylnaphthalene having dissolved therein 5 parts by weight of terephthalic acid dichloride were added 1.4 parts by weight of rhodamine B lactam so as to dissolve therein. The rhodamine B lactam solution was mixed with an aqueous solution of 3 parts by weight of polyvinyl alcohol in 97 parts by weight of water and the mixture was emulsified and dispersed with a homogenizer to give a dispersion having a mean particle diameter of 10μ. An aqueous solution of 3 parts by weight of diethylene triamine and 3 parts by weight of sodium carbonate in 24 parts by weight of water was added to the dispersion. The mixture was allowed to stand for 24 hours while stirring to give a capsule solution containing rhodamine B lactam as a core material.

Next, the microcapsules were collected by filtration and 50 parts by weight of the microcapsules were mixed with 50 parts by weight of barium sulphate, 10 parts by weight of styrene-butadiene latex, and 150 parts by weight of water. The mixture was stirred to give a capsule slurry. The capsule slurry was subjected to spray drying using a spray drier for experimental use under conditions comprising an inlet temperature of 130°C, an outlet temperature of 80°C, a pressure of 3.0 kg/cm², and a solution feed rate of 7 ml/min to give Microcapsules B containing barium sulphate in the wall and rhodamine B lactam as the core material.

(Microcapsules C)

To 45 parts by weight of diisopropylnaphthalene having dissolved therein 5 parts by weight of terephthalic acid dichloride were added 1.4 parts by weight of 3-CP-aminophenyl phthalide so as to dissolve therein. The 3-CP-aminophenyl phthalide solution was mixed with an aqueous solution of 3 parts by weight of polyvinyl alcohol in 97 parts by weight of water and the mixture was emulsified and dispersed with a homogenizer to give a dispersion having a mean particle diameter of 10μ. An aqueous solution of 3 parts by weight of diethlene triamine and 3 parts by weight of sodium carbonate in 24 parts by weight of water was added to the dispersion. The mixture was allowed to stand for 24 hours while stirring to give a capsule solution containing 3-CP-aminophenyl phthalide as a core material.

Next, the microcapsules were collected by filtration and 50 parts by weight of the microcapsules were mixed with 50 parts by weight of magnesium silicate, 10 parts by weight of styrene-butadiene latex and 150 parts by weight of water. The mixture was stirred to give a capsule slurry. The capsule slurry was subjected to spray drying using a spray drier for experimental use under conditions comprising an inlet temperature of 130°C, an outlet temperature of 80°C, a pressure of 3.0 kg/cm² and a solution feed rate of 7 ml/min to give Microcapsules C containing magnesium silicate in the wall and 3-CP-aminophenyl phthalide as the core material.

(Dispersion)

To 100 parts by weight of 5% polyvinyl alcohol aqueous solution were added 30 parts by weight of bisphenol A. The mixture was dispersed for 24 hours in a ball mill to give a dispersion of bisphenol A.

To 40 parts by weight of the bisphenol A dispersion were added 20 parts by weight of the Microcapsules A and 20 parts by weight of the Microcapsules B thus obtained. The mixture was stirred and made into a coating solution. The coating solution was coated onto wood free paper of 50 g/m² in an amount of 20 g/m² (dry weight) using a wire bar. The coating solution was then dried to give a multicolour image producing material.

A record was made on the multicolour image producing material at an output of 1.0 W and a scanning rate of 2 m/sec using a carbon dioxide laser having a wavelength of 10.6 μ to give colour images having a clear cyan colour. Next, a record was made on the said material at an output of 1.0 W and a scanning rate of 2 m/sec using a carbon dioxide laser having a wavelength of 9.2μ to give colour images having a clear magenta colour. The cyan and magenta colour images showed no colour contamination at all.

Example 2

A multicolour image producing material was obtained in a manner similar to Example 1 except that Microcapsules C were used in place of the Microcapsules B.

A record was made on the multicolour image producing material under the same conditions as in Example 1 using a carbon dioxide laser having a wavelength of $10.6\mu$ and then using a carbon dioxide laser having a wavelength of $9.6\mu$ to give colour images having clear cyan and yellow colours. The cyan and yellow colour images showed no colour contamination at all.

## Example 3

A multicolour image producing material was obtained in a manner similar to Example 1 except that Microcapsules C were used in place of the Microcapsules A.

A record was made on the multicolour image producing material under the same conditions as in Example 1 using a carbon dioxide laser having a wavelength of $9.2\mu$ and then using a carbon dioxide laser having a wavelength of $9,6\mu$ to give colour images having clear magenta and yellow colours. The magenta and yellow colour images showed no colour contamination at all.

## Example 4

To 60 parts by weight of a bisphenol A dispersion were added 20 parts by weight of the Microcapsules A, 20 parts by weight of the Microcapsules B and 20 parts by weight of the Microcapsules C described in Example 1. The mixture was stirred and made into a coating solution. The coating solution was coated onto wood free paper of 50 $g/m^2$ in an amount of 20 $g/m^2$ (dry weight) using a wire bar. The coating solution was then dried to give a multicolour image producing material.

A record was made on the multicolour image producing material under the same conditions as in Example 1 using carbon dioxide lasers having wavelengths of $10.6\mu$, $9.2\mu$ and $9.6\mu$ to give colour images having clear cyan, magenta and yellow colours. The cyan, magenta and yellow colour images showed no colour contamination at all.

## Example 5

Figure 6 is a schematic view illustrating a second embodiment of an image producing material according to the present invention which comprises a substrate 62 coated with porous micro-globules 63 each impregnated with a heat-meltable substance containing either one of cyan, magenta, and yellow colour forming leuco dyes 65 dispersed therein, enclosed in a material 66, 67, 68 respectively which absorbs a laser beam of a wavelength which varies according to the colour concerned. The microglobules 63 are homogeneously mixed with each other in a binder 64 in which a developer material is dispersed.

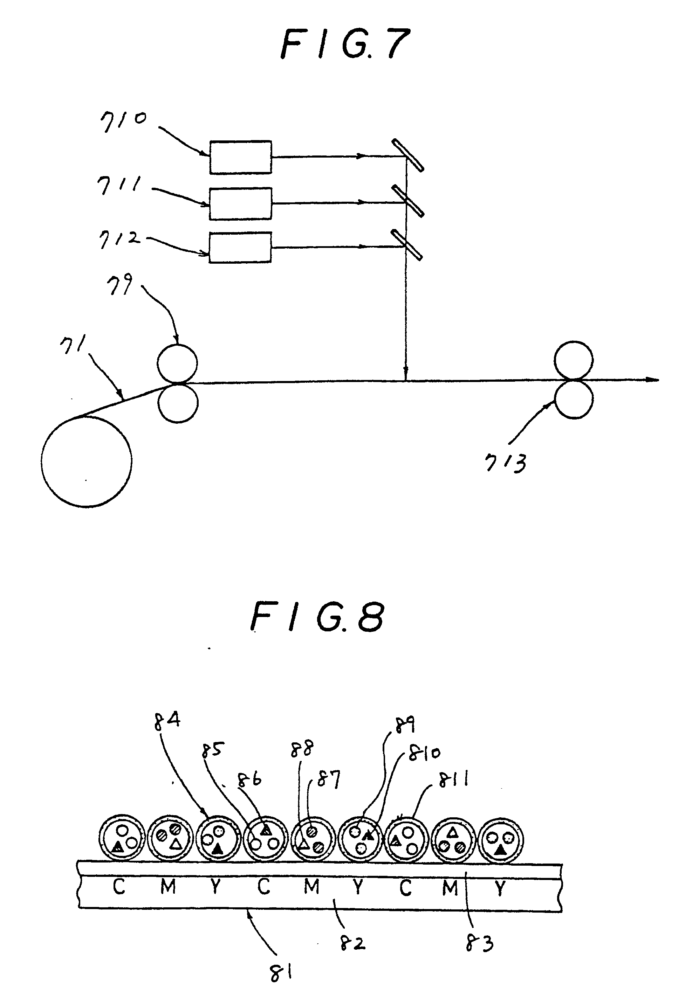

Figure 7 is an illustration of the use of laser beam radiation to produce a multicolour image by employing the image producing material shown in Figure 6.

When the laser beams having the wavelengths $\lambda_1, \lambda_2$, and $\lambda_3$ are applied to the image producing material according to signals corresponding to the three primary colours, e.g. by using a CRT, the porous micro-globules 63 for the individual colours independently generate heat, thereby causing the heat-meltable substance to be fused. This brings about the reaction of the leuco dyes for the individual colours with the respective developer materials to develop the colours, thereby forming a colour image comprised of cyan, magenta, and yellow.

The leuco dyes and developer materials which may be used in this example include the same compounds as given above.

Examples of heat-meltable substances which may be used include waxes such as paraffin wax, montan wax, and polyethylene wax, and low-boiling resins such as ethylene-acrylate copolymers and butadiene-styrene copolymers.

Examples of laser beam absorbing materials include inorganic oxides, phthalocyanines, and quaternary ammonium salts.

As shown in Figure 6, the developer material and binder 64, which reacts with the leuco dyes 65 to form the colours, is coated on the substrate 62 and the three kinds of porous micro-globules 63 containing cyan leuco dye, magenta leuco dye and yellow leuco dye respectively, are coated as a homogeneous mixture thereon. The porous micro-globules of cyan, magenta or yellow contain a material 66 capable of absorbing a laser beam having a wavelength of $\lambda_1$, a material 67 capable of absorbing a laser beam having a wavelength of $\lambda_2$, and a material 68 capable of absorbing a laser beam having a wavelength of $\lambda_3$, respectively. The porous micro-globules 63 include the leuco dyes and the heat-meltable substance as a core material.

In Figure 7, the reference numerals 710, 711 and 712 indicate an oscillator for a laser beam having a wavelength of $\lambda_1$, $\lambda_2$ and $\lambda_3$ respectively. The reference numerals 79 and 713 indicate pinch rollers. An image producing sheet 71 is exposed to three kinds of laser beams having mutually different wavelengths from the oscillators 710, 711 and 712, thereby forming a multicolour image in one process.

## Example 6

Another embodiment of the present invention will now be described as follows. The embodiment comprises exposing a substrate coated with a homogeneous mixture of three kinds of microcapsules respectively containing any one of cyan, magenta and yellow dyes to a laser beam, thereby forming a multicolour image which is of a high quality and which is produced at a high speed in one process.

Figure 8 is a schematic view of a laser colour image producing material. In Figure 8, an image producing material or sheet 81 comprises a substrate 82 coated with a colour developing layer 83 containing a developer material uniformly dispersed therein. On the layer 83 there is formed a homogeneous mixture of three kinds of microcapsules 84 respectively containing core material comprised of a combination of any one of cyan-, magenta-, and yellow-developing leuco dyes 85, 87 and 89 with a corresponding decolourizing agent 86, 88 and 810. The leuco dyes and the decolourizing agents, which form the core materials of the microcapsules, are enclosed in a resin 811 which fuses at a temperature which varies according to the kind of colour to be developed. The three kind of microcapsules respectively for cyan, magenta, and yellow each have a capsule wall containing a laser beam absorbing material which generates heat upon being exposed to a laser beam.

The microcapsules respectively for cyan, magenta, and yellow are exposed to three kinds of laser beams having mutually different energy levels so that they develop colours at e.g. temperatures of $T_1$, $T_2$, and $T_3$ ($T_1 < T_2 < T_3$), respectively. The microcapsule for cyan is formed so that a cyan decolourizing agent does not fuse until the temperature reaches $T_2$ although a cyan leuco dye fuses at a temperature of $T_1$. In this case, the cyan leuco dye reacts with the developer at a temperature of $T_1$ to develop a colour. The micro-capsule for magenta is formed so that a magenta decolourizing agent does not fuse until the temperature reaches $T_3$ although a magenta leuco dye fuses at a temperature of $T_2$. In this case, the magenta leuco dye reacts with the developer at a temperature of $T_2$ to develop a colour. At this temperature, the cyan decolourizing agent fuses in the microcapsule for cyan, which prevents the cyan leuco dye from developing a colour. Further, since the microcapsule for yellow does not develop a colour until the temperature reaches $T_3$, only magenta is developed at a temperature of $T_2$. The microcapsule for yellow is formed so that a yellow decolourizing agent does not fuse until the temperature reaches $T_4$ ($> T_3$) although a yellow leuco dye fuses at a temperature of $T_3$. In this case, the yellow leuco dye reacts with the developer at a temperature of $T_3$ to develop a colour. At this temperature, the decolourizing agents in the microcapsules for cyan and magenta fuse, which prevents the cyan, magenta, and yellow leuco dyes from developing colours. Thus, the microcapsules respectively for cyan, magenta, and yellow independently develop colours at different temperatures, which permit the production of a multicolour image in one process through radiation of three kinds of laser beam having mutually different energy levels.

The leuco dyes which may be used in the present Example include compounds as described above.

Examples of the decolourizing agent which may be used include polyethylene oxide, polyoxydecamethylene, oleyl ether, tripropylcarbinol, 2,5-dimethyl-3-hexy-2, 5-diol, and pentamethylglycerin.

Examples of the developer which may be used include phenolic compounds such as α-naphthol, β-naphthol, resorcinol, hydroquinone, catechol, and pyrogallol, activated clay, and metal salts of organic carboxylic acids.

Examples of the heat-meltable substance which may be used for enclosing the leuco dye and the decolourizing agent therein include waxes such as paraffin wax, montan wax, and polyethylene wax, and low boiling resins such as ethylene-acrylate copolymer, butadiene and styrene copolymer.

Examples of the laser beam absorbing material which may be used include inorganic oxides, phthalocyanines, and quaternary ammonium salts.

The process for forming colour images employing the sheet 81 shown in Figure 8 is similar to that above described with reference to Figure 7.

When the laser colour recording sheet 81 is exposed to laser beams $\lambda_1$, $\lambda_2$, and $\lambda_3$ having mutually different energy levels so as to raise the temperature of the microcapsules 84 respectively to $T_1$, $T_2$ and $T_3$, the corresponding microcapsules 84 of the laser colour recording sheet 81 develop colour for use in producing a multicolour image.

As described above, the multicolour images may be produced at high speed in a simple process utilizing a plurality of infra-red rays of different wavelengths, use being made of a multicolour record producing material comprising a substrate having provided thereon at least two microcapsules or porous micro-globules separately containing therein colour formers of respective colours capable of forming at least two different colours, and colour developers capable of reacting with the respective colour formers to form colours, the at least two microcapsules or porous micro-globules containing infra-red absorbents responsive to different wavelengths for the respective colours in the wall or at the surface thereof.

## Claims

1. An image producing material comprising a substrate (41) which carries a plurality of colour containers (43) each of which contains a colour former (1) which is released when the respective colour container (43) is subjected to a predetermined process, the image producing material comprising developer material (42) with which the respective colour former (1), when so released, reacts to produce a colour image characterised in that each of the colour containers (43) comprises infra-red absorbent material (3) which produces the said release of the colour former (1) when the respective colour container (43) is subjected to infra-red light of a predetermined wavelength ($\lambda_1$, $\lambda_2$, $\lambda_3$).

2. An image producing material as claimed in claim 1 characterised in that each colour container is a heat-meltable microcapsule (43) which is caused to melt when the respective infra-red absorbent material is subjected to infra-red light of a predetermined wavelength ($\lambda_1$, $\lambda_2$, $\lambda_3$).

3. An image producing material as claimed in claim 2 characterised in that respective microcapsules (43) contain colour formers (1) of different colours, each microcapsule (43) comprising infra-red absorbent material (3) which is responsive to infra-red light whose wavelength differs from that to which the infra-red absorbent material (3) of a colour container (43) which contains a colour former (1) of a different colour is responsive.

4. An image producing material as claimed in claim 3 characterised in that the microcapsules comprise first microcapsules (C) containing a cyan colour former and infra-red absorbent material responsive to a first wavelength ($\lambda_1$), second microcapsules (M) containing a magenta colour former and infra-red absorbent material responsive to a second wavelength ($\lambda_2$), and third microcapsules (Y) containing a yelow colour former and infra-red absorbent material responsive to a third wavelength.

5. An image producing material as claimed in any preceding claim characterised in that the colour containers (43) are in a layer which is provided on a developer material layer (42) or which contains developer material (64).

6. An image producing material as claimed in claim 2 or in any claim appendant thereto characterised in that each microcapsule (43) has a porous membrane (2,6) within which the colour former (1) is encapsulated.

7. An image producing material as claimed in claim 6 characterised in that each microcapsule (43) has inner and outer capsule walls (2,4), the porous membrane (2) constituting one of the capsule walls.

8. An image producing material as claimed in claim 7 characterised in that the infra-red absorbent material (3) is located in the other capsule wall.

9. An image producing material as claimed in claim 6 characterised in that the porous membrane (6) constitutes an outer capsule wall which contains the infra-red absorbent material (3).

10. An image producing material as claimed in claim 6 characterised in that each microcapsule (43) has an inner capsule wall which contains the infra-red absorbent material (3) and an outer capsule wall which is made from a heat-meltable substance.

11. An image producing material as claimed in claim 2 or in any claim appendant thereto characterised in that each microcapsule (3) comprises a porous micro-globule (5) which contains the colour former (1), the micro-globule (5) being encapsulated in an outer layer (6).

12. An image producing material as claimed in any preceding claim in which each colour former (1) comprises a leuco dye.

13. A process for forming a colour image by the use of the image producing material claimed in claim 4 or in any claim appendant thereto characterised by resolving a multicolour image into its red, green and blue component parts; causing each of said component parts to generate a respective actinic infra-red ray whose wavelength ($\lambda_1$, $\lambda_2$, $\lambda_3$) differs from that of the other said rays; directing the said rays onto the microcapsules (C,M,Y) so that the latter are heated by adsorbing the said rays; and producing a multicolour image by causing or permitting the colour formers of the microcapsules to react with the developer material (42).

## Revendications

1. Une matière de génération d'image, comprenant un substrat (41) qui porte un ensemble de réceptacles de couleur (43), chacun d'eux contenant un agent de formation de couleur (1) qui est libéré lorsque le réceptacle de couleur respectif (43) est soumis à un processus prédéterminé, la matière de génération d'image comprenant une matière de développement (42) avec laquelle l'agent de formation de couleur respectif (1), lorsqu'il est ainsi libéré, réagit pour produire une image en couleurs, caractérisée en ce que chacun des réceptacles de couleur (43) comprend une matière absorbant l'infrarouge (3) qui produit la libération précitée de l'agent de formation de couleur (1) lorsque le réceptacle de couleur respectif (43) est soumis à l'action de lumière infrarouge d'une longueur d'onde prédéterminée ($\lambda_1$, $\lambda_2$, $\lambda_3$).

2. Une matière de génération d'image selon la revendication 1, caractérisée en ce que chaque réceptacle de couleur est une micro-capsule (43) pouvant fondre sous l'effet de la chaleur, qui fond lorsque la matière respective absorbant l'infrarouge est soumise à l'action de lumière infrarouge d'une longueur d'onde prédéterminée ($\lambda_1$, $\lambda_2$, $\lambda_3$).

3. Une matière de génération d'image selon la revendication 2, caractérisée en ce que des micro-capsules (43) respectives contiennent des agents de formation de couleur (1) de différentes couleurs, chaque micro-capsule (43) comprenant une matière absorbant l'infrarouge (3) qui réagit à de la lumière infrarouge dont la longueur différente de celle à laquelle réagit la matière absorbant l'infrarouge (3) d'un réceptacle de couleur (43) qui contient un agent de formation de couleur (1) d'une couleur différente.

4. Une matière de génération d'image selon la revendication 3, caractérisée en ce que les micro-capsules comprennent des premières micro-capsules (C) contenant un agent de formation de couleur cyan et une matière absorbant l'infrarouge qui est sensible à une première longueur d'onde ($\lambda_1$), des secondes micro-capsules (M) contenant un agent de formation de couleur magenta et une matière absorbant l'infrarouge qui est sensible à une seconde longueur d'onde ($\lambda_2$), et des troisièmes micro-capsules (Y) qui contiennent un agent de formation de couleur jaune et une matière absorbant l'infrarouge qui est sensible à une troisième longueur d'onde.

5. Une matière de génération d'image selon l'une quelconque des revendications précédentes, caractérisée en ce que les réceptacles de couleur (43) se trouvent dans une couche qui est formée sur une couche de matière de développement (42), ou qui contient une matière de développement (64).

6. Une matière de génération d'image selon la revendication 2 ou l'une quelconque des revendications qui lui sont rattachées, caractérisée en ce que chaque microcapsule (43) comporte une membrane poreuse (2, 6) à l'intérieur de laquelle l'agent de formation de couleur (1) est encapsulé.

7. Une matière de génération d'image selon la revendication 6, caractérisée en ce que chaque micro-capsule (43) comporte des parois de capsule intérieure et extérieure (2, 4), et la membrane poreuse (2) constitue l'une des parois de capsule.

8. Une matière de génération d'image selon la revendication 7, caractérisée en ce que la matière absorbant l'infrarouge (3) se trouve dans l'autre paroi de capsule.

9. Une matière de génération d'image selon la revendication 6, caractérisée en ce que la membrane poreuse (6) constitue une paroie de capsule extérieure qui contient la matière absorbant l'infrarouge (3).

10. Une matière de génération d'image selon la revendication 6, caractérisée en ce que chaque micro-capsule (43) comporte une paroi de capsule intérieure qui contient la matière absorbant l'infrarouge (3), et une paroi de capsule extérieure qui est constituée par une substance pouvant fondre sous l'effet de la chaleur.

11. Une matière de génération d'image selon la revendication 2 ou l'une quelconque des revendications qui lui sont rattachées, caractérisée en ce que chaque microcapsule (3) comprend un micro-globule poreux (5) qui contient l'agent de formation de couleur (1), et ce microglobule (5) est encapsulé dans une couche extérieure (6).

12. Une matière de génération d'image selon l'une quelconque des revendications précédentes, dans laquelle chaque agent de formation de couleur (1) consiste en un leucodérivé de colorant.

13. Un procédé de formation d'une image en couleur par l'utilisation d'une matière de génération d'image selon la revendication 4 ou l'une quelconque des revendications qui lui sont rattachées, caractérisé en ce qu'on décompose une image polychrome en composantes rouge, verte et bleue correspondantes; on fait en sorte que chacune de ces composantes génère un rayonnement infrarouge actinique respectif dont la longueur d'onde ( $\lambda_1$, $\lambda_2$, $\lambda_3$ ) diffère de celle des autres rayonnements; on dirige ces rayonnements sur les micro-capsules (C, M, Y), de façon que ces dernières soient chauffées par l'absorption des rayonnements précités; et on produit une image polychrome en provoquant ou en permettant la réaction des agents de formation de couleur des microcapsules avec la matière de développement (42).

## Patentansprüche

1. Bilderzeugendes Material, umfassend
-ein Substrat (41). das eine Vielzahl von Farbbehältern (43) trägt, von denen jeder einen Farbbildner (1) enthält, welcher freigegeben wird, wenn der betreffende Farbbehälter (43) einem vorbestimmten Prozeß unterzogen wird, und -Entwicklermaterial (42), mit dem der freigegebene Farbbildner (1) zur Erzeugung eines Farbbildes reagiert,
**dadurch gekennzeichnet,**
daß jeder der Farbbehälter (43) Infrarotstrahlung absorbierendes Material (3) enthält, welches die Freigabe des Farbbildners (1) bewirkt, wenn der betreffende Farbbehälter (43) einer Infrarotstrahlung mit einer vorbestimmten Wellenlänge ($\lambda_1$, $\lambda_2$, $\lambda_3$ ) ausgesetzt wird.

2. Bilderzeugendes Material nach Anspruch 1,
**dadurch gekennzeichnet,**
daß jeder Farbbehälter eine durch Erwärmung schmelzbare Mikrokapsel (43) ist, die zum Schmelzen gebracht wird. wenn das jeweilige Infrarotstrahlung absorbierende Material einer Infrarotstrahlung mit einer vorbestimmten Wellenlänge ($\lambda_1$, $\lambda_2$, $\lambda_3$ ) ausgesetzt wird.

3. Bilderzeugendes Material nach Anspruch 2,
**dadurch gekennzeichnet,**
daß die jeweiligen Mikrokapseln (43) Farbbildner (1) unterschiedlicher Farben enthalten und daß jede Mikrokapsel (43) Infrarotstrahlung, absorbierendes Material (3) aufweist. das auf Infrarotstrahlung reagiert. deren Wellenlänge sich von der Wellenlänge unterscheidet. auf die das Infrarotstrahlung absorbierende Material (3) eines einen Farbbildner (1) einer anderen Farbe enthaltenden Farbbehälters (43) reagiert.

4. Bilderzeugendes Material nach Anspruch 3,
**dadurch gekennzeichnet,**

daß die Mikrokapseln erste Mikrokapseln (C) . die einen Cyan-Farbbildner und Infrarotstrahlung absorbierendes Material enthalten. das auf eine erste Wellenlänge ($\lambda_1$) reagiert. zweite Mikrokapseln (M). die einen Magenta-Farbbildner und Infrarotstrahlung absorbierendes Material enthalten, das auf eine zweite Wellenlänge ($\lambda_2$) reagiert, und dritte Mikrokapseln (Y). die einen Gelb-Farbbildner und Infrarotstrahlung absorbierendes Material enthalten. das auf eine dritte Wellenlänge ($\lambda_3$) reagiert, umfassen.

5. Bilderzeugendes Material nach wenigstens einem der vorhergehenden Ansprüche,
**dadurch gekennzeichnet,**
daß die Farbbehälter (43) in einer Schicht vorgesehen sind, die auf einer Entwicklermaterialschicht (42) angeordnet ist oder Entwicklermaterial (64) enthält.

6. Bilderzeugendes Material nach Anspruch 2 oder irgendeinem auf Anspruch 2 bezogenen Anspruch,
**dadurch gekennzeichnet,**
daß jede Mikrokapsel (43) eine poröse Membran (2, 6) aufweist. in der der Farbbildner (1) eingekapselt ist.

7. Bilderzeugendes Material nach Anspruch 6,
**dadurch gekennzeichnet,**
daß jede Mikrokapsel (43) innere und äußere Kapselwände (2, 4) aufweist und daß die poröse Membran (2) eine der Kapselwände (2, 4) bildet.

8. Bilderzeugendes Material nach Anspruch 7,
**dadurch gekennzeichnet,**
daß das Infrarotstrahlung absorbierende Material (3) in der anderen Kapselwand vorgesehen ist.

9. Bilderzeugendes Material nach Anspruch 6,
**dadurch gekennzeichnet,**
daß die poröse Membran (6) eine äußere Kapselwand bildet. die das Infrarotstrahlung absorbierende Material (3) enthält.

10. Bilderzeugendes Material nach Anspruch 6,
**dadurch gekennzeichnet,**
daß jede Mikrokapsel (43) eine das Infrarotstrahlung absorbierende Material (3) enthaltende innere Kapselwand und eine äußere Kapselwand aufweist. die aus einer durch Erwärmung schmelzbaren Substanz gebildet ist.

11. Bilderzeugendes Material nach Anspruch 2 oder irgendeinem auf Anspruch 2 bezogenen Anspruch,

**dadurch gekennzeichnet,**
daß jede Mikrokapsel ein in einer äußeren Schicht (6) eingekapseltes poröses Mikrokügelchen (5) umfaßt. das den Farbbildner (1) enthält.

12. Bilderzeugendes Material nach wenigstens einem der vorhergehenden Ansprüche,
    **dadurch gekennzeichnet,**
    daß jeder Farbbildner (1) einen Leuko-Farbstoff enthält.

13. Verfahren zur Erzeugung eines Farbbildes unter Verwendung des bilderzeugenden Materials nach Anspruch 4 oder irgendeinem auf Anspruch 4 bezogenen Anspruch,
    **dadurch gekennzeichnet,**
    daß man ein mehrfarbiges Bild in seine Rot, Grün und Blau- Komponenten auflöst.
    jede der Komponenten zur Erzeugung eines jeweiligen aktinischen Infrarotstrahles heranzieht. dessen Wellenlänge ($\lambda_1$, $\lambda_2$, $\lambda_3$ ) sich von der der anderen Infrarotstrahlen unterscheidet.
    die Strahlen auf die Mikrokapseln (C, M, Y) richtet, so daß letztere durch Absorption der Strahlen erwärmt werden, und ein mehrfarbiges Bild erzeugt, indem man die Farbbildner der Mikrokapseln mit dem Entwicklermaterial (42) reagieren läßt.

# FIG.1

# FIG.2

# FIG.3

# FIG.4

# F I G. 5

43

$\lambda_1$     $\lambda_2$     $\lambda_3$

C M Y C M Y C M Y C M Y C M Y C M Y C M Y C M Y C

50     50     50     51     51   42     52

51

52

41

# F I G. 6

66
67
68                                        65
                                            64
                                              63

C M Y C M Y C M Y C M Y C

61                                        62

# FIG.7

710
711
712
79
71
713

# FIG.8

84
85
86
88
87
89
810
811

C M Y C M Y C M Y
82
83
81